Europäisches Patentamt

European Patent Office

Office européen des brevets

(19)

(11) Veröffentlichungsnummer: **0 103 730**

**A2**

(12) # EUROPÄISCHE PATENTANMELDUNG

(21) Anmeldenummer: **83107840.7**

(22) Anmeldetag: **09.08.83**

(51) Int. Cl.³: **G 06 K 17/00**

(30) Priorität: **16.09.82 DE 3234345**

(43) Veröffentlichungstag der Anmeldung:
**28.03.84 Patentblatt 84/13**

(84) Benannte Vertragsstaaten:
**CH DE FR GB IT LI**

(71) Anmelder: **ROBERT BOSCH GMBH**
**Robert-Bosch-Strasse 7 Postfach 429**
**D-6100 Darmstadt(DE)**

(72) Erfinder: **Hesser, Paul**
**Katharinenstrasse 9**
**D-7141 Freiberg a.N.(DE)**

(54) **Kodiersystem zur Erfassung von Informationen an Werkstückträgern und dergleichen.**

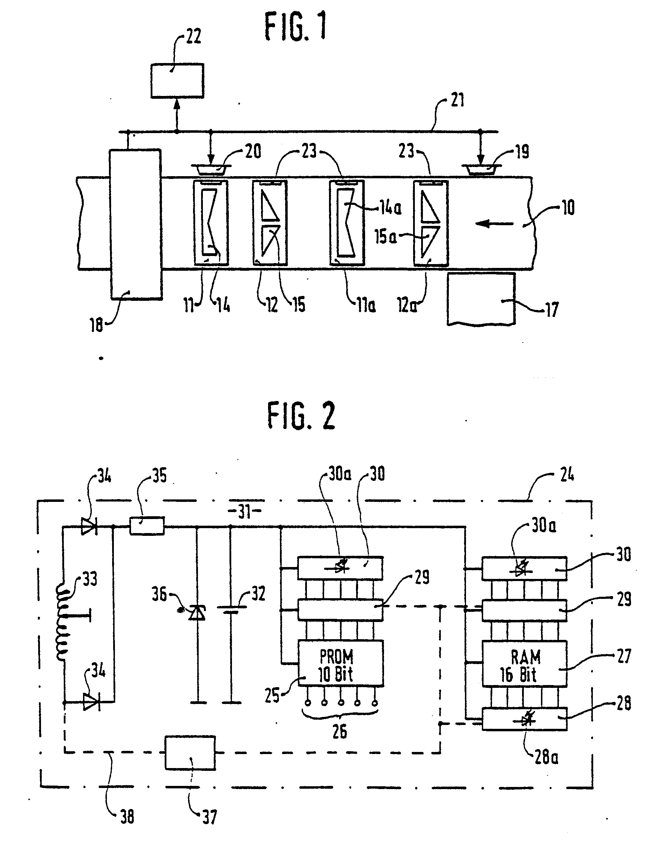

(57) Es wird ein Kodiersystem zur Erfassung von Informationen an mobilen Werkstücken oder Werkstückträgern vorgeschlagen, die zur Steuerung von Fertigungsabläufen oder anderen automatisierbaren Vorgängen dient, indem die Informationen als Bit-Muster in einem Informationsträger gespeichert und mittels stationär angebrachten Sensoren berührungslos abtastbar sind. Als Informationsträger (21) dient ein elektronischer Speicherblock (24, 40), der eine Eingabe zum Einschreiben von Informationen in den Speicherblock sowie eine Informationsausgabe zum Auslesen des Speicherinhaltes durch stationäre Sensoren (19, 20) aufweist (Figur 1).

FIG. 1

EP 0 103 730 A2

R. 18053
8.89.1982 Ws/Hm

ROBERT BOSCH GMBH, 7000 STUTTGART 1

Kodiersystem zur Erfassung von Informationen an
Werkstückträgern und dergleichen

Stand der Technik

Bei bekannten Kodiersystemen von Werkstückträgern oder
Werkstücken, die sich zur Weiterbearbeitung, Zusammensetzung oder Sortierung auf einer Fertigungsstraße oder
dgl. befinden, werden Informationen zur Kennung des einzelnen Werkstückträgers bzw. Werkstückes, zum Bearbeitungszustand bzw. zur Lage oder zum Montagefortschritt
in einen Informationsträger eingegeben und dort als Bit-
muster gespeichert, so daß sie an sogenannten Lesestationen im Bereich der Fertigungsstraße mittels stationär
angebrachten Sensoren berührungslos abgetastet werden
können.

Eine solche bekannte Kodiereinrichtung besteht aus einem
Lagerbock mit Kodierbolzen, der sich auf dem Werkstückträger befindet. Kodiert und Dekodiert wird durch Verschieben der in den Endlagen einrastenden Bolzen. Die
Abfrage der Bolzenstellung erfolgt durch induktive
Näherungsschalter (Sensoren), durch Lichtreflexion an
den Stirnseiten der Bolzen bzw. durch Lichtschranken.

. . .

Werden mehrere Kodierbolzen untereinander oder nebeneinander angeordnet, kann die Zahl der kodierten Informationen am Informationsträger erhöht werden. So wird z.B. an einer bestimmten Bearbeitungsstation ein entsprechender Kodierbolzen nach vollzogenem Bearbeitungsvorgang am Werkstück durch eine entsprechende Vorrichtung eingedrückt. Der vollzogene Bearbeitungs- oder Montageschritt wird von einer Lesestation der folgenden Bearbeitungsstation erkannt und das zu bearbeitende Werkstück wird dort dementsprechend weiterbehandelt. Bei flexiblen Montagebändern mit gleichartigen, nebeneinander angeordneten Werkstückträgern wird auf einem Hauptband der Fertigungsstraße durch die entsprechende Kodierung am Werkstückträger erkannt, welche Bearbeitungsvorgänge jeweils vollzogen sind und welcher Bearbeitungsstation der Werkstückträger zuzuführen ist.

Ferner ist ein Kodiersystem bekannt, bei dem die Kodierbolzen jeweils paarweise angeordnet und so miteinander verbunden sind, daß beim Eindrücken des einen Kodierbolzens der andere Kodierbolzen aus dem Informationsträger herausgedrückt wird. Die Kodierbolzen werden paarweise durch induktive Sensoren abgetastet (DE-OS 30 12 358). Derartige Kodiersysteme haben allerdings den Nachteil, daß in dem für den Informationsträger vorhandenen Platz am Werkstückträger nur relativ wenig Informationen untergebracht werden können, da die Abstände der Kodierbolzen ausreichend groß sein müssen, um Fehler beim Speichern oder Lesen der Information zu vermeiden. Außerdem ist das Einschreiben und Auslesen von Informationen am Informationsträger nur bei stillstehendem Werkzeugträger möglich, wodurch der Fertigungsablauf in vielen Fällen beeinträchtigt wird. Ferner unterliegen die Kodierbolzen dem Verschleiß, insbesondere

...

bei häufigen Änderungen der Kodierung in Fertigungsstraßen,
die in hohem Maße Schmutz, Feuchtigkeit und Staub ausgesetzt sind.

Neben den mechanischen Kodiersystemen sind auch optisch
lesbare Kodiersysteme bekannt, die insbesondere beim Verteilen und Erfassen verpackter Waren bevorzugt eingesetzt werden. In einem bestimmten Feld werden dabei eine
Vielzahl dicker oder dünner Striche auf die Verpackung
aufgebracht, welche dann durch optische Sensoren ablesbar sind. Eine Änderung der dekodierten Information ist
hierbei aber nicht möglich. Außerdem sind magnetische
Kodiersysteme an Werkstückträgern bekannt, bei denen die
Information mit Hilfe starker Magnetfelder auf den Informationsträger, z.B. ein magnetisierbarer Sinterwerkstoff bzw. eine Metallfläche aufgebracht werden. Die Abfrage der Information wird in der Regel über Hall-Sonden
oder induktive Sensoren vorgenommen, die aber in sehr geringem Abstand zum Informationsträger angeordnet sein
müssen. Die Informationen können mit einem Wechselfeld
wieder gelöscht und anschließend neu auf den Informationsträger aufgebracht werden. Durch die magnetischen
Streufelder ist jedoch die Informationsdichte am Informationsträger begrenzt, so daß bei einer größeren Anzahl
von Informationen der erforderliche Platz vielfach nicht
vorhanden ist. Außerdem besteht die Gefahr, daß sich
Eisenspäne an den magnetisierten     Stellen des Inforamtionsträgers festsetzen und das Ablesen der gespeicherten Information verhindern.

Mit der vorliegenden Lösung wird angestrebt, in
möglichst kleinen Informationsträgern,die an mobilen
Werkstücken oder Werkstückträgern angebracht sind, eine
Vielzahl von Informationen in möglichst kurzer Zeit über
stationäre Schreib- und Lesestationen störungssicher einzuschreiben bzw. auszulesen.

. . .

## Vorteile der Erfindung

Die erfindungsgemäße Lösung mit den kennzeichnenden Merkmalen des Hauptanspruchs hat den Vorteil, daß die kompakten elektronischen Speicherblöcke für eine Vielzahl von Prozeßsteuerungen an Fließbändern oder dgl. anwendbar ist. Der Speicherblock ist gegen Feuchtigkeit und Verschmutzung unempfindlich und arbeitet nahezu ohne Verschleiß. Außerdem können je nach Aufbau des Speicherblocks Informationen mechanisch, elektrisch, elektromagnetisch oder optisch eingeschrieben werden und sie können seriell oder parallel optisch oder elektromagnetisch ausgelesen werden. Als weiterer Vorteil ist anzusehen, daß eine Änderung des Speicherinhalts durch Verschmutzung, Schüttel- oder Schwingbeanspruchung nicht möglich ist und daß der Speicherblock ohne besondere Wartung eine relativ hohe Lebensdauer hat. Ferner ist es möglich, zwischen dem Speicherblock und einer zentralen Fertigungsleitstelle über die Lese- und Schreibstationen einen Informationsaustausch vorzunehmen, um den Fertigungsablauf zu optimieren. Bei einer entsprechend hohen Übertragungsfrequenz zwischen Schreib- und Lesestationen einerseits und dem Speicherblock andererseits können die erforderlichen Informationen auch im Vorbeilaufen des Werkstückträgers ausgetauscht werden.

Durch die in den Unteransprüchen aufgeführten Maßnahmen sind vorteilhafte Weiterbildungen und Verbesserungen der im Hauptanspruch angegebenen Merkmale möglich. Als besonders vorteilhaft ist anzusehen, wenn der Speicherblock einen programmierbaren, nicht flüchtigen Halbleiterspeicher (PROM) sowie einen überschreibbaren Halbleiterspeicher (RAM) enthält, so daß in dem programmierbaren, nicht flüchtigen Halbleiterspeicher die Kenninformation für

...

- 5 -

den Werkstückträger bzw. für das Werkstück und in den überschreibbaren Halbleiterspeicher die verschiedenen, mit dem
Fortschreiten der Fertigung hinzukommenden bzw. sich teilweise ändernden Informationen abgelegt sind.

Zeichnung

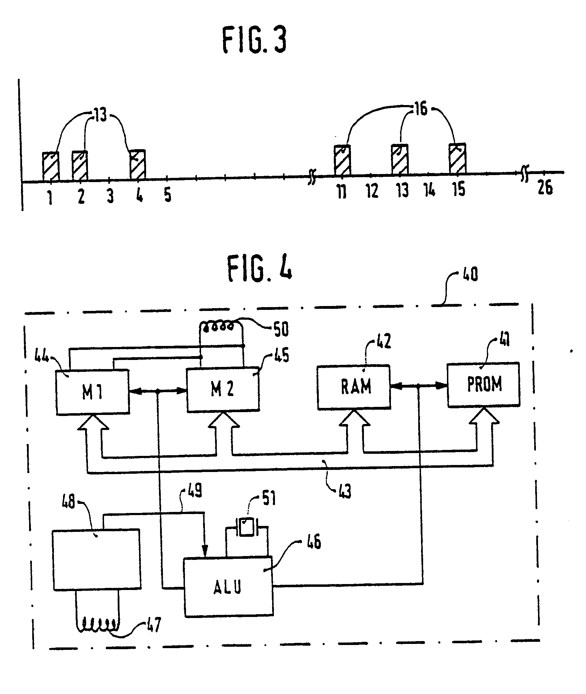

Zwei Ausführungsbeispiele der Erfindung sind in der Zeichnung dargestellt und in der nachfolgenden Beschreibung
näher erläutert. Es zeigen Figur 1 die schematische
Darstellung des Abschnittes einer Fertigungsstraße mit
Werkstückträgern sowie mit stationären Schreib- und
.Lesestationen, Figur 2 der Aufbau eines Speicherblocks
nach der Erfindung, Figur 3 zeigt ein Bitmuster von
im Speicherblock nach Figur 2 gespeicherten Informationen
und Figur 4 zeigt einen anderen Speicherblock für eine
serielle Dateneingabe und -ausgabe.

Beschreibung der Ausführungsbeispiele

In Figur 1 ist ein Ausschnitt aus einer Fertigungsstraße
schematisch dargestellt. Ein mit 10 bezeichnetes Fließband wird dabei kontinuierlich in Pfeilrichtung bewegt.
Auf dem Fließband 10 sind mehrere Werkstückträger 11, 11a
und 12, 12a abgestellt, die jeweils verschieden gestaltete
Werkstücke 14, 14a, 15, 15a tragen. Durch eine Sortiervorrichtung 17 werden die Werkstücke 14, 15 in stets
gleicher Folge auf das Fließband 10 gegeben und in einer
Montagevorrichtung 18 werden diese Werkstücke paarweise
zu einer Einheit zusammengesetzt. Gegenüber der Sortiervorrichtung 17 liegt eine Schreib- und Lesestation 19.
Ferner befindet sich vor der Montagevorrichtung 18 an

...

- 6 -

der gleichen Seite des Fließbandes 10 noch eine Lesestation
20. Sämtliche Lese- und Schreibstationen und Vorrichtungen
der Fertigungsstraße sind über elektrische Leitungen 21
mit einer Leitsteuerung 22 z.B. mit einem Zentralprozessor
verbunden. Die Schreib- und Lesestationen 19 und 20 wirken
mit Informationsträgern 23 zusammen, die jeweils an der
entsprechenden Seite eines jeden Werkstückträgers 11, 12
angebracht sind.

Sobald nun ein Werkstückträger 12a von der Sortiervorrichtung 17 auf dem Fließband 10 abgesetzt ist, wird von der
Schreib- und Lesestation 19 zunächst die im Informationsträger 23 gespeicherte Information ausgelesen, das im Werkstückträger befestigte Werkstück wird identifiziert und es
wird anschließend eine neue Information über den nächsten
Fertigungsschritt in den Informationsträger 23 eingeschrieben. Gelangt nun dieser Werkstückträger 12a zur
nächsten Lesestation 20, so wird diese neue Information
dort wieder ausgelesen und die Montagevorrichtung 18
wird aufgrund dieser Information das Werkstück 13a mit
dem dazu gehörenden anderen Werkstück 14a in richtiger
Weise zusammenfügen.

Um eine Vielzahl von Informationen im Informationsträger
23 aufnehmen zu können, ist dieser als elektronischer
Speicherblock ausgestaltet. Figur 2 zeigt einen solchen
elektronischen Speicherblock 24 in seinem schematischen
Aufbau. Der Speicherblock 24 enthält einen programmierbaren, nicht flüchtigen Halbleiterspeicher 25, der im
weiteren als PROM bezeichnet wird. Der PROM 25 ist mit
einer 10-Bit-Information zu belegen, die den jeweiligen
Werkstückträger 11, 12 kennzeichnet. Diese Information

...

- 7 -

wird über einen Eingang 26 durch Anlegen entsprechender
Spannungen einmalig in dem PROM 25 eingeschrieben und
bleibt dann unverändert stehen. Neben dem PROM ist ein
umprogrammierbarer Halbleiterspeicher 27 angeordnet,
in dem 16 Bit-Informationen sowohl eingeschrieben als
auch ausgelesen werden können. Dieser im folgenden als
RAM bezeichnete Speicher 27 hat eine mit 16 Sensoren
versehene Eingabe 28, wobei die nicht dargestellten
Sensoren Fotodioden, Fototransistoren, Hall-Elemente
oder andere licht-, magnetfeld- oder druckabhängige
Halbleiterelemente sein können, die jeweils mit integrierten Verstärkerstufen zusammenwirken. Im Beispielsfall soll die Eingabe 28 mit Fotodioden 28a ausgestattet
sein. PROM 25 und RAM 27 sind außerdem jeweils über
eine Treiberstufe 29 mit einer Informationsausgabe
30 verbunden, in der ebenfalls 10 bzw. 16 Halbleiterelemente angeordnet sind, welche optische oder magnetische Signale abgeben können. Im Beispielsfall ist
die Informationsausgabe 30 jeweils mit 10 bzw. 16
GAs-Dioden 30a zur Signalabe ausgestattet.

Die Halbleiterspeicher 25 und 27 sind als ICs auf einem
Substrat 31, z.B. auf einer Leiterplatte aufgebracht.
Ebenso sind die Treiberstufen 29 sowie die Eingabe 28
und die Informationsausgaben 30 als Schaltungsbausteine auf dem Substrat 31 aufgebracht. Die Spannungsversorgung sämtlicher elektronischer Bauteile erfolgt
über einen Akkumulator 32, der von einer Induktionsspule 33 über zwei Gleichrichterdioden 34 sowie einem
Widerstand 35 aufladbar ist. Parallel zum Akkumulator
32 liegt eine 5 V Z-Diode 36 zur Spannungsbegrenzung. Die
Induktionsspule 33 wird dabei an den Schreib- und Lesestationen 19, 20 durch ein hochfrequentes Magnetfeld
mit elektromagnetischer Energie versorgt, so daß der

. . .

Akkumulator 32 eine relativ kleine Speicherkapazität
aufweisen kann und ggf. durch einen Kondensator ersetzt
werden kann.

Verwendet man an den Informationsausgaben 30 Leuchtdioden, so lassen sich damit die im PROM 25 und im RAM
27 gespeicherten Informationen beim Anlegen der Versorgungsspannung jederzeit ablesen. Da hierfür aber
eine relativ große Energiequelle benötigt wird, kann
vorgesehen werden, daß die Informationen nur an den
Schreib- und Lesestationen 19, 20 auf die Informationsausgabe 30 gelangen. Zu diesem Zweck ist eine Steuerlogik 37 vorgesehen, die über eine gestrichelt dargestellte Verbindung 38 an die Induktionsspule 33 einerseits und an die Eingabe 28 sowie an die Informationsausgaben 30 andererseits angeschlossen ist. Sobald nun
an einer Schreib- und Lesestation 19, 20 Energie auf die
Induktionsspule 33 eingekoppelt wird, werden die Treiberstufen 29 zur Informationsausgabe aktiviert. Ferner
kann über die Induktionsspule 33 ein Einschreibbefehl auf die Steuerlogik 37 gegeben werden, durch den
die Eingabe 28 aktiviert wird. Hat dagegen die Informationsausgabe 30 einen geringen Stromverbrauch, so
genügt es, wenn die Induktionsspule 33 nur an den
Schreibstationen 19 mit Energie versorgt wird. In diesem Fall wird die Steuerlogik 37 nur solange einzuschreibende Informationen von der Eingabe 28 in das
RAM 27 durchschalten, wie der Speicherblock 24 mit
der Energieversorgung der Schreibstation 19 in
Verbindung steht.

Figur 3 zeigt das Bit-Muster von Informationen, wie sie
beispielsweise im Speicherblock 24 nach Figur 2 abgelegt
sein können. Die ersten zehn Stellen enthalten Bit-Informationen 13 zur Kennung des Werkstückträgers 12, 13.

...

An den nachfolgenden Stellen 11 bis 26 werden Bit-Informationen 16 über das Werkstück im Werkstückträger gespeichert. So kann beispielsweise bei verschiedenen, zusammenzufügenden Werkstücken die Stellen 11 und 12 eine Information über das jeweilige Werkstück enthalten, während die nachfolgenden Stellen 13 bis 18 eine Information über die bereits durchlaufenen Stationen speichert. Den restlichen Stellen können weitere Informationen über gemessene Werte des Werkstücks, über die Lage des Werkstücks und dgl. gespeichert werden. Da die Informationen im Speicherblock 24 parallel eingeschrieben bzw. ausgelesen werden, ergibt sich eine hohe Übertragungsgeschwindigkeit, so daß der Informationsaustausch an den Schreib- und Lesestationen 19, 20 im Vorbeilaufen der Werkstückträger 11, 13 erfolgt.

In Figur 4 ist als weiteres Ausführungsbeispiel ein Speicherblock für einen seriellen Informationsaustausch dargestellt. Auch dieser Speicherblock 40 ist mit einem PROM 41 und mit einem RAM 42 versehen. Im RAM 42 sind beispielsweise 50 Adressen vorgesehen, so daß 50 verschiedene Informationen in ihm gespeichert sind. Auch der PROM 41 hat im Beispielsfall mehrere Speicheradressen, so daß im Bedarfsfalle mehrere Informationen fest gespeichert werden können. Über einen Datenbus 43 sind PROM 41 und RAM 42 mit zwei Multiplexern 44 und 45 verbunden, wobei der Multiplexer 44 als Informationseingabe für das RAM 42 dient und der Multiplexer 45 als Informationsausgabe für das PROM 41 und das RAM 42 dient. Die jeweilige Ansteuerung der Multiplexer 44 und 45 sowie der entsprechenden Halbleiterspeicher PROM 41 und RAM 42 erfolgt über eine Steuerlogik 46. Über eine Induktionsspule 47 wird an den Schreib- und Lesestationen 19, 20 durch ein hochfrequentes Magnetfeld elektromagnetische Energie auf den Speicherblock 40 übertragen und in einer Versorgungs-

...

stufe 48 zur kontinuierlichen Spannungsversorgung der einzelnen IC-Bauteile 41-46 gespeichert. Dem Magnetfeld mit
einer sogenannten Grundfrequenz von etwa 50 kHz werden an
den Schreib- und Lesestationen 19, 20 Steuerbefehle überlagert, die in der Versorgungsstufe 48 ausgekoppelt und
über eine Leitung 49 auf die Steuerlogik 46 gegeben
werden. Durch diese Steuerbefehle wird der Steuerlogik
46 mitgeteilt, ob Informationen in das RAM 42 über den
Multiplexer 44 seriell eingeschrieben oder ob die im
PROM 41 und im RAM 42 gespeicherten Informationen über
den Multiplexer 45 seriell ausgelesen werden sollen.
Zum Einschreiben und Auslesen dieser Informationen ist
eine Übertragerspule 50 vorgesehen, die sowohl mit dem
Eingang des Multiplexers 44 als auch mit dem Ausgang
des Multiplexers 45 verbunden ist. Die Übertragungsgeschwindigkeit der Informationen wird dabei durch
einen Schwingquarz 51 in der Steuerlogik 46 bestimmt.

Wird nun im Beispielsfall ein Werkstückträger 11 mit
einem Speicherblock 40 an der Schreib- und Lesestation
19 vorbeibewegt, so gelangt zunächst das dort erzeugte
hochfrequente Magnetfeld zur Energieversorgung des Speicherblocks 40 auf die Induktionsspule 47 und teilt der
Steuerlogik 46 mit, daß eine Schreib- bzw. Lesestation
erreicht ist. Die Steuerlogik 46 steuert daraufhin den
PROM 41 und den Multiplexer 45 in der Art an, daß die
im PROM 41 gespeicherte Information zur Identifizierung des Werkstückträgers 11 in Form von seriellen
Impulsen auf die Übertragerspule 50 gegeben wird und
von dort über einen entsprechenden magnetischen Sensor der Station 19 ausgelesen wird. Die Station 19
erkennt jetzt, daß ein bestimmter Werkstückträger 10
die Station 19 erreicht hat. Mit einem Steuerbefehl
der Station 19 wird nun über die Induktionsspule 47 die

...

Steuerlogik 46 angewiesen, alle übrigen im PROM 41 und im RAM 42 abgelegten Informationen oder nur ganz bestimmte, entsprechend adressierte Informationen an der Übertragerspule 50 seriell auszulesen. Diese Informationen werden nun von der Station 19 zur Leitsteuerung 22 gemeldet, dort werden sie geprüft und ggf. wird anschließend eine neue Information ausgegeben, welche über die Station 19 zunächst durch einen Steuerbefehl die Steuerlogik 46 anweist, den Multiplexer 44 und das RAM 42 mit einer bestimmten Adresse zum Einschreiben einer Information vorzubereiten. Anschließend wird an der Übertragerspule 50 die Information durch serielle Impulse von der Station 19 übernommen und an der bestimmten Adresse im RAM 42 eingeschrieben. Im Bedarfsfall kann nun noch mit einem weiteren Steuerbefehl die eingelesene Information nochmals abgerufen und überprüft werden. Der Speicherblock 40 kann auf diese Weise an jeder Bearbeitungsstation aktualisiert werden, d.h., daß der Bearbeitungsfortschritt oder das Meßergebnis und dgl. an den entsprechenden Stationen im RAM 42 als binäre Informationen eingeschrieben werden.

Die in Figur 2 und in Figur 4 dargestellten Speicherblöcke 24 und 40 können in ihrem Aufbau variiert und kombiniert werden. So können beispielsweise die im PROM 41 und im RAM 42 gespeicherten Informationen durch eine zusätzliche Anzeige mittels GAs-Dioden oder durch LCD-Elemente sichtbar gemacht werden. Verwendet man leistungsarme Bausteine im Speicherblock, so kann die Energieversorgung durch eine im Speicherblock einzusetzende Knopfzelle (Batterie) sichergestellt werden. Es ist aber ebenso möglich, auf einen Akkumulator oder auf eine Knopfzelle ganz zu verzichten und den Speicherblock nur an den Schreib- und/oder Lesestationen 19, 20 durch ein hochfrequentes Magnetfeld mit elektrischer Energie zu versorgen. In diesem Fall erfolgt die Energieversorgung des Speicherblocks über eine Induktionsspule, einen Gleichrichter und einem Glättungselement. Anstelle eines RAMs ist dann aber ein überschreibbarer, nicht flüchtiger Halbleiterspeicher, z.B. ein EAROM, ein EEPROM oder ein NOV-RAM zu verwenden, da diese Halbleiterspeicher ihre Informationen im spannungslosen Zustand behalten. Außerdem kann in Weiterbildung der Erfindung die Energieversorgung, die Informationsübertragung und die Übertragung von Steuerbefehlen auf die Steuerlogik des Speicherblocks über ein und dieselbe Induktionsspule erfolgen, indem der Grundfrequenz des an den Schreib- und/oder Lesestationen 19, 20 erzeugten Magnetfeldes von z.B. 10 kHz in der Induktionsspule zeitlich nacheinander verschiedene Steuersignale und einzuschreibende bzw. auszulesende Informationen durch Impulse höherer Frequenz z.B. 30-50 kHz überlagert werden.

Im Rahmen der Erfindung ist es außerdem möglich, zur Energieversorgung für den Speicherblock anstelle eines hochfrequentes Magnetfeldes einen Akkumulator vorzusehen, der an bestimmten Ruheplätzen oder in Ruhezeiten automatisch mit einem Ladegerät verbunden und nachgeladen wird. Den Anforderungen in einer mechanisch und klimatisch stark beanspruchten Fertigungsstraße dürfte eine induktive Energie- und Datenübertragung am besten gerecht werden. In anderen Bereichen, insbesondere bei geringerer Schmutzbelastung an den Fließbändern ist eine optische Datenübertragung sinnvoll, weil hierfür größere Abstände zwischen den Schreib- und Lesestationen einerseits und dem Werkstückträger oder dem Werkstück andererseits möglich sind. In allen Anwendungsfällen ist aber der

...

erfindungsgemäße Speicherblock als Modul am Werkstück oder
am Werkstückträger bzw. Trägerelement abnehmbar oder auswechselbar anzubringen. Ein solcher Modul ist jeweils mit
einer Eingabe zum Einschreiben von Informationen in den
elektronischen Speicherblock sowie mit einer Informationsausgabe zum Auslesen des Speicherinhaltes durch stationäre
Sensoren versehen, die an entsprechenden Gebern bzw. Sensoren der Schreib- und Lesestationen vorbeigeführt werden.

Die Erfindung ist nicht auf den Einbau in Werkstückträgern
beschränkt. Durch die geometrische und elektrische Ausbildung der Übertragerspulen 47 und 50 lassen sich große
Abstände und Abstandstoleranzen zwischen ihnen und den
Schreib- und Lesestationen verwirklichen. Damit wird
das System für alle Komponenten der Ver- und Entsorgung
z.B. für Lager, Fördertechnik, Zufuhrtechnik, Transport-
mittel- und Hilfsmittel einsetzbar.

**0103730**

R. 18055
8.9.1982 Ws/Hm

ROBERT BOSCH GMBH, 7000 STUTTGART 1

Ansprüche

1. Kodiersystem zur Erfassung von Informationen über die Kennung sowie über den Bearbeitungs-, Montage- und/oder Lagezustand von mobilen Werkstücken bzw. Werkstückträgern bei Fertigungsstraßen oder dgl., wobei der Werkstückträger bzw. das Werkstück mit einem Informationsträger versehen ist, dessen Informationen als Bit-Muster gespeichert und mittels stationär angebrachten Sensoren berührungslos abtastbar ist, dadurch gekennzeichnet, daß der Informationsträger ein elektronischer Speicherblock (24, 40) ist, der eine Eingabe (28, 44) zum Einschreiben von Informationen in den Speicherblock (24, 40) sowie eine Informationsausgabe (30, 45) zum Auslesen des Speicherinhaltes durch die stationären Sensoren (19, 20) aufweist.

2. Kodiersystem nach Anspruch 1, dadurch gekennzeichnet, daß der elektronische Speicherblock (24, 40) einen programmierbaren, nicht flüchtigen Halbleiterspeicher (25, 41) enthält.

3. Kodiersystem nach Anspruch 2, dadurch gekennzeichnet, daß der elektronische Speicherblock (24, 40) einen fest programmierbaren und einen umprogrammierbaren Halbleiterspeicher (25, 27, 41, 42) enthält.

...

4. Kodiersystem nach Anspruch 2 oder 3, dadurch gekennzeichnet, daß der elektronische Speicherblock (24, 40)
einen überschreibbaren, nichtflüchtigen Halbleiterspeicher (EEPROM) enthält.

5. Kodiersystem nach einem der vorherigen Ansprüche,
dadurch gekennzeichnet, daß die Informationsausgabe
(30) mehrere lichtabstrahlende Halbleiterelemente enthält.

6. Kodiersystem nach einem der vorherigen Ansprüche,
dadurch gekennzeichnet, daß der Inhalt des Halbleiterspeichers (27) optisch angezeigt und über die Informationsausgabe (30) von stationär angeordneten Lesestationen (19, 20) abtastbar ist.

7. Kodiersystem nach einem der vorherigen Ansprüche,
dadurch gekennzeichnet, daß die Eingabe (28) zum Einschreiben von Informationen in den Speicherblock (24)
mehrere Sensoren enthält.

8. Kodiersystem nach Anspruch 7, dadurch gekennzeichnet, daß die Sensoren magnetfeld-, licht- oder druckabhängige Halbleiterelemente sind.

9. Kodiersystem nach einem der vorherigen Ansprüche,
dadurch gekennzeichnet, daß Informationen von stationär
angeordneten Schreibstationen (19) in den Halbleiterspeicher (27, 42) über seinen Eingang (28, 45) einschreibbar sind.

10. Kodiersystem nach Anspruch 9, dadurch gekennzeichnet, daß die Informationen nur solange über die Eingabe (28, 45) des Halbleiterspeichers (27, 42) ein-

. . .

bar sind, wie der Speicherblock (24, 40) mit einer Energieversorung in Verbindung steht.

11. Kodiersystem nach einem der Ansprüche 1 bis 3, dadurch gekennzeichnet, daß die Halbleiterspeicher (41, 42) über die Informationsausgabe (45) und über die Informationseingabe (44) von einer Steuerlogik (46) mit einem induktiven Übertrager (50) zu verbinden sind, über den die Informationen seriell eingegeben und ausgegeben werden.

12. Kodiersystem nach Anspruch 13, dadurch gekennzeichnet, daß die Informationen des Halbleiterspeichers (41, 42) über einen Multiplexer (45) seriell auszugeben sind.

13. Kodiersystem nach Anspruch 12, dadurch gekennzeichnet, daß der Übertrager (50) mit einem ersten Multiplexer (44) als Informationseingabe und einem zweiten Multiplexer (45) als Informationsausgabe verbunden ist.

14. Kodiersystem nach Anspruch 13, dadurch gekennzeichnet, daß die Multiplexer (44, 45) und die Halbleiterspeicher (41, 42) über die Steuerlogik (46) durch Steuerbefehle der Schreib- und/oder Lesestationen (19, 20) auf die Eingabe oder Ausgabe von Informationen umsteuerbar bzw. ansteuerbar sind.

15. Kodiersystem nach Anspruch 14, dadurch gekennzeichnet, daß die von einer Schreib- und/oder Lesestation (19, 20) abgegebenen Steuerbefehle über eine Induktionsspule (33, 47) auf die Steuerlogik (37, 46) gelangen.

...

16. Kodiersystem nach Anspruch 15, dadurch gekennzeichnet, daß die Energieversorgung des Speicherblocks (24,
40) mit einem hochfrequenten Magnetfeld über eine Induktionsspule (33, 47), einen Gleichrichter (34, 48) und
einen Glättungselement (32) erfolgt.

17. Kodiersystem nach Anspruch 16, dadurch gekennzeichnet, daß zur Energieversorgung die Induktionsspule
(33) mit einem Akkumulator (32) verbunden ist, an dem
die Spannungsversorgung sämtlicher Bauelemente (25-30)
des Speicherblocks (24) angeschlossen sind.

18. Kodiersystem nach Anspruch 16, dadurch gekennzeichnet, daß die Induktionsspule an den Schreib- und
Lesestationen (19, 20) zur Energieversorgung mit einem
Magnetfeld durchsetzt ist, welches eine bestimmte Grundfrequenz hat, dem die Steuerbefehle für die Steuerlogik (37, 48) überlagert sind.

19. Kodiersystem nach Anspruch 18, dadurch gekennzeichnet, daß der Grundfrequenz des Magnetfeldes in
der Induktionsspule zeitlich nacheinander Steuerbefehle sowie in den Speicherblock einzuschreibende und
aus dem Speicherblock auszulesende Informationen mit
höherer oder niedrigerer Frequenz überlagert sind.

20. Kodiersystem nach einem der vorherigen Ansprüche,
dadurch gekennzeichnet, daß die Halbleiterspeicher (25,
27, 41, 42) als integrierte Schaltungen gemeinsam mit
der Steuerlogik (37, 46) und allen übrigen Schaltelementen und Sensoren des Speicherblocks auf ein Substrat
(31) aufgebracht und in Isolierstoff eingebettet sind.

...

21. Kodiersystem nach einem der vorherigen Ansprüche, dadurch gekennzeichnet, daß der Speicherblock (24, 40) als Modul an einem Trägerelement (11, 12) oder einem Werkstück (14, 15) abnehmbar bzw. auswechselbar angebracht ist.

0103730

## FIG. 1

## FIG. 2

# FIG. 3

# FIG. 4